# FASCICULE DE BREVET EUROPEEN

(11) **EP 2 945 161 B1**
(45) Date de publication et mention de la délivrance du brevet: **22.03.2017**
(21) Numéro de dépôt: 15167406.6
(22) Date de dépôt: 12.05.2015
(51) Int. Cl.: G11C 13/00

(54) **PROCEDE DE DE DETERMINATION DE PARAMETRES DE PROGRAMMATION SERVANT A PROGRAMMER UNE MEMOIRE VIVE RESISTIVE**
VERFAHREN ZUR BESTIMMUNG DER PROGRAMMIERUNGSPARAMETER, DIE ZUM PROGRAMMIEREN EINES RESISTIVEN ARBEITSSPEICHERS DIENEN
METHOD FOR DETERMINING PROGRAMMING PARAMETERS FOR PROGRAMMING A RESISTIVE RANDOM-ACCESS MEMORY

(30) Priorité: 15.05.2014 FR 1454346
(43) Date de publication de la demande: 18.11.2015
(73) Titulaire: COMMISSARIAT A L'ENERGIE ATOMIQUE ET AUX ENERGIES ALTERNATIVES, 75015 Paris (FR)
(72) Inventeur: Cabout, Thomas, 38000 Grenoble (FR); Vianello, Elisa, 38000 Grenoble (FR)
(74) Mandataire: Cabinet Camus Lebkiri

(56) Documents cités:
- US-A1- 2011 235 401
- YANG YIN CHEN ET AL: "Improvement of data retention in HfO<inf>2</inf>/Hf 1T1R RRAM cell under low operating current", 2013 IEEE INTERNATIONAL ELECTRON DEVICES MEETING, 1 décembre 2013 (2013-12-01), pages 10.1.1-10.1.4, XP055173058, DOI: 10.1109/IEDM.2013.6724598 ISBN: 978-1-47-992306-9

## Description

### DOMAINE TECHNIQUE DE L'INVENTION

La présente invention concerne le domaine des mémoires réinscriptibles non volatiles, et plus spécifiquement celui des mémoires vives résistives de type OxRRAM et CBRAM. Une mémoire vive résistive comprend des première et seconde électrodes séparées par une couche en matériau électriquement isolant, et passe d'un état isolant à un état conducteur par application d'une tension seuil VSET entre les première et seconde électrodes.

### ARRIERE-PLAN TECHNOLOGIQUE DE L'INVENTION

En fonction des applications et des performances visées, différents types de mémoires sont utilisées.

Ainsi, les mémoires de type SRAM, ou mémoires vives statiques, offrent des temps d'écriture ultra-rapides, requis par exemple lors de calculs par un micro-processeur. L'inconvénient majeur de ces mémoires est qu'elles sont volatiles et que la taille du point mémoire relativement grande ne permet pas d'obtenir une grande capacité de stockage dans un volume raisonnable.

Les mémoires de type DRAM, ou mémoires vives dynamiques, réalisant le stockage de charges électriques dans des capacités, offrent une grande capacité de stockage. Ces mémoires possèdent toutefois des temps d'écriture plus élevés (quelques dizaines de nanosecondes) que ceux des mémoires de type SRAM et sont elles aussi volatiles, le temps de rétention de l'information étant de l'ordre de quelques dizaines de millisecondes.

A l'inverse, pour des applications qui nécessitent un stockage de l'information même lorsque la tension est coupée, on connait également des dispositifs mémoire à l'état solide qui conservent l'information en l'absence d'alimentation : ces dispositifs sont appelés mémoires non volatiles. Ainsi, depuis de nombreuses années, différentes solutions technologiques ont été développées, et ont conduit à la disponibilité de mémoires non volatiles pouvant être écrites et effacées électriquement. On peut citer par exemple :
- les EPROMs (« Erasable Programmable Read Only Memories » en anglais, ou mémoires mortes effaçables et programmables), dont le contenu peut être écrit électriquement, mais qui doivent être soumises à un rayonnement UV pour effacer les informations mémorisées ;
- les EEPROMs (« Electrically Erasable Programmable ROMs » en anglais, ou mémoires mortes effaçables et programmables électriquement), dont le contenu peut être écrit et effacé électriquement, mais qui requièrent, pour leur réalisation, des surfaces de semi-conducteur plus importantes que les mémoires de type EPROM, et qui sont donc plus coûteuses à réaliser.

Les deux solutions mentionnées ci-dessus présentant des limites dans leur application, les fabricants se sont mis à la recherche d'une mémoire non volatile idéale, qui combinerait les caractéristiques suivantes : écriture et effacement électrique, haute densité et faible coût par bit, accès aléatoire, temps d'écriture et de lecture courts, bonne endurance, mais aussi faible consommation et faible tension d'alimentation.

Il existe également des mémoires non volatiles, appelées mémoires Flash, qui ne présentent pas les inconvénients des mémoires EPROMs ou EEPROMs mentionnés ci-dessus. En effet, une mémoire Flash est formée d'une pluralité de cellules mémoires pouvant être programmées électriquement de manière individuelle, un grand nombre de cellules, appelé bloc, secteur ou page, pouvant être effacées simultanément et électriquement. Les mémoires Flash combinent à la fois l'avantage des mémoires EPROMs en termes de densité d'intégration et l'avantage des mémoires EEPROMs en termes d'effacement électrique.

De plus, la durabilité et la faible consommation électrique des mémoires Flash les rendent intéressantes pour de nombreuses applications : appareils photos numériques, téléphones cellulaires, imprimantes, assistants personnels, ordinateurs portables, ou encore dispositifs portables de lecture et d'enregistrement sonore, clés USB, etc. De plus, les mémoires Flash ne possèdent pas d'éléments mécaniques, ce qui leurs confère une assez grande résistance aux chocs. A l'ère du « tout numérique », ces produits se sont grandement développés, permettant une explosion du marché des mémoires Flash.

La plupart des mémoires Flash non-volatiles du commerce utilisent le stockage de charges comme principe de codage de l'information. En pratique, une couche de piégeage de charge (généralement du polysilicium, ou un diélectrique comme le SiN) est encapsulée entre deux diélectriques dans l'empilement de grille d'un transistor MOS. La présence ou l'absence de charge dans ce medium modifie la conduction du transistor MOS et permet de coder l'état de la mémoire.

Plus récemment, d'autres types de mémoires non volatiles réinscriptibles sont apparus pour réduire les tensions et temps de programmation des mémoires Flash ; on peut notamment citer les mémoires ferroélectriques (mémoires FeRAM ou « Ferroelectric RAM »), basées sur le basculement de la polarisation, ou les mémoires magnétiques (mémoires MRAM ou « Magnetic RAM) qui utilisent la direction du champ magnétique rémanent dans le matériau actif. Cependant, les mémoires FeRAM et MRAM présentent des difficultés qui limitent leur réduction d'échelle.

Afin de surmonter ces difficultés, on connait les mémoires à résistance variable (appelées mémoires RRAM ou « Resistive RAM ») ; ces dernières sont aujourd'hui le sujet d'une grande attention. Les mémoires de type résistive peuvent présenter au moins deux états « off » ou « on » correspondant au passage d'un état résistif (état « HRS ») à un état moins résistif (état « LRS »)).

Les mémoires vives à résistance variable sont aujourd'hui le sujet d'une grande attention, en raison notamment de leur faible consommation électrique et leur vitesse de fonctionnement élevée.

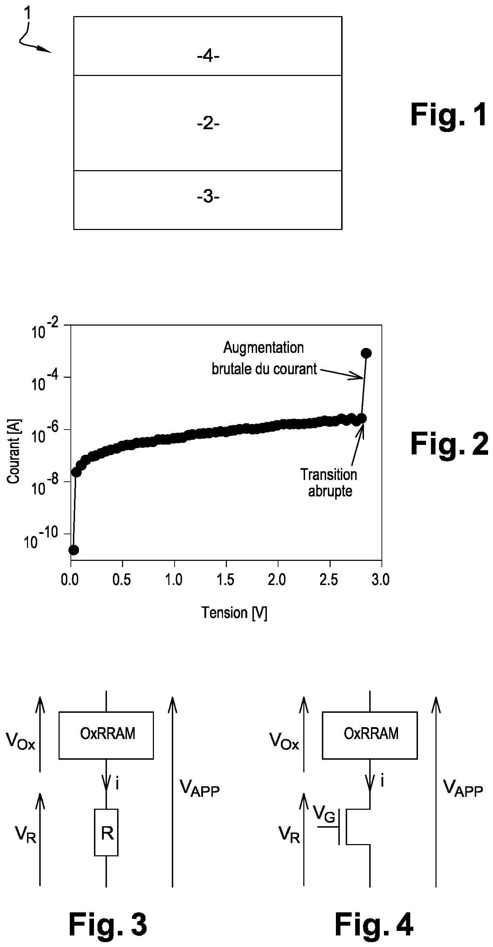

Les données binaires 0 ou 1 sont stockées dans une structure Métal/Isolant/Métal (MIM) présentant deux états de résistance distincts. La figure 1 représente la structure d'une cellule mémoire RRAM 1 de type MIM. Ce dispositif 1 est formé par un empilement comportant une zone active de mémorisation 2 disposée entre une électrode inférieure conductrice 3 et une électrode supérieure conductrice 4.

Ainsi, la cellule mémoire de type résistive peut basculer de manière réversible d'un état fortement résistif « HRS » (« High Resistance State »), appelé également état « OFF », vers un état faiblement résistif « LRS » (« Low Resistance State ») ou état « ON ». Elle peut donc être utilisée pour stocker une information binaire.

Le mécanisme d'écriture est appelé SET dans le cadre des RRAM et consiste à passer de l'état HRS à l'état LRS. Pour effacer l'information, le matériau actif est commuté de l'état LRS vers l'état HRS, le mécanisme d'effacement étant appelé RESET. Les états LRS et HRS sont tous les deux conducteurs (avec bien entendu une meilleure conduction de l'état LRS par rapport à l'état HRS) ; or dans l'état initial, le matériau actif de la zone active de mémorisation 2 est isolant (état PRS, « Pristine Resistance State »). Un premier stress électrique doit donc être appliqué sur la cellule mémoire vierge afin de générer l'état LRS pour la première fois. Le processus associé, appelé FORMING, consiste en un claquage partiellement réversible du matériau actif, c'est-à-dire qu'après le passage de l'état isolant PRS à l'état conducteur LRS, la résistance de l'état conducteur peut être basculée sur l'état HRS avec un stress électrique plus faible (opération de RESET).

Le phénomène de changement de résistance est observé dans différents types de matériaux, ce qui suggère des mécanismes de fonctionnement différents. On peut ainsi distinguer plusieurs types de mémoires résistives.

Le domaine de la présente invention concerne plus particulièrement deux catégories de mémoires résistives :
- les mémoires comportant une zone active basée sur un matériau actif à base d'oxyde (mémoire OxRRAM ou « Oxyde RRAM ») tel qu'un oxyde binaire d'un métal de transition ;
- les mémoires comportant une zone active basée sur un matériau à conduction ionique (mémoires CBRAM ou « Conductive Bridging RAM ») formant un électrolyte solide à conduction ionique disposé entre une électrode formant une cathode inerte et une électrode comportant une portion de métal ionisable, c'est-à-dire une portion de métal pouvant facilement former des ions métalliques, et formant une anode.

Le fonctionnement des mémoires CBRAM est basé sur la formation, au sein de l'électrolyte solide, d'un ou plusieurs filaments métalliques (appelés également « dendrites ») entre ses deux électrodes lorsque ces électrodes sont portées à des potentiels appropriés. La formation du filament permet d'obtenir une conduction électrique donnée entre les deux électrodes. En modifiant les potentiels appliqués aux électrodes, il est possible de modifier la répartition du filament, et de modifier ainsi la conduction électrique entre les deux électrodes. Par exemple, en inversant le potentiel entre les électrodes, il est possible de faire disparaître ou de réduire le filament métallique, de manière à supprimer ou à réduire considérablement la conduction électrique due à la présence du filament. A l'état « HRS », les ions métalliques issus de la portion de métal ionisable de l'électrode soluble sont dispersés dans tout l'électrolyte solide. Ainsi, aucun contact électrique n'est établi entre la cathode et l'anode, c'est-à-dire entre l'électrode supérieure et l'électrode inférieure. L'électrolyte solide comporte une zone électriquement isolante de grande résistivité entre l'anode et la cathode. Lorsqu'un potentiel VSET positif est appliqué sur l'anode, une réaction d'oxydoréduction a lieu à cette électrode, créant des ions mobiles. Les ions se déplacent alors dans l'électrolyte sous l'effet du champ électrique appliqué aux électrodes. Arrivés à l'électrode inerte (la cathode), les ions sont réduits, entraînant la croissance d'un filament métallique. Le filament croît préférentiellement dans la direction de l'électrode soluble. La mémoire passe alors dans l'état « LRS » lorsque le filament permet le contact entre les électrodes, rendant l'empilement conducteur. Cette phase constitue le « SET » de la mémoire.

Pour passer à l'état « HRS » (phase de « RESET » de la mémoire), une tension VRESET négative est appliquée sur l'anode, entrainant la dissolution du filament conducteur.

S'agissant des mémoires OxRRAM, comme pour les mémoires CBRAM, le modèle filamentaire bénéficie d'un large consensus. Il repose donc également sur la formation et la rupture d'un ou plusieurs chemins de conduction (filaments conducteurs) dans la matrice d'oxyde, connectant les deux électrodes. La formation et la rupture des filaments conducteurs sont attribuées à la présence de lacunes d'oxygène.

Il est important de noter que, dans le cas des OxRRAM comme dans le cas des CBRAM, l'opération de SET permet de faire passer la cellule mémoire d'un état haute résistance HRS à un état basse résistance LRS. Comme évoqué plus haut, le SET est réalisé en appliquant une tension suffisante VSET aux bornes de l'élément mémoire. La transition entre l'état haute et basse résistance (proche d'un claquage d'oxyde dans le cas d'une mémoire OxRRAM) est très rapide et se traduit par une augmentation brutale du courant lorsque la tension VSET est atteinte. Cette augmentation est illustrée en figure 2. Cette augmentation brutale du courant n'est pas autolimitée. Si rien n'est fait pour contrôler cette augmentation le courant va augmenter jusqu'à des valeurs très élevées susceptibles d'entrainer une augmentation très importante de la température et une destruction du dispositif mémoire. Il est donc nécessaire de limiter par une compliance l'augmentation du courant jusqu'à une certaine valeur afin d'obtenir un état basse résistance tout en gardant un dispositif mémoire intègre. Ce courant limité est appelé indifféremment limitation de courant ou courant d'ajustement (« compliance » en anglais).

La limitation de courant nécessaire pendant l'opération d'écriture peut être réalisée par différents moyens tels qu'une résistance ou un transistor en série avec la mémoire : l'ajout d'une résistance ou d'un transistor en série permet de limiter le courant passant dans l'ensemble point mémoire et résistance/transistor série.

L'utilisation d'une résistance R (illustrée en figure 3) mise en série avec l'élément mémoire (ici une mémoire OxRRAM) permet de limiter le courant. La présence de la résistance série permet de limiter le courant qui passe dans l'ensemble une fois que la cellule OxRRAM est commutée dans l'état basse résistance. Au début de l'opération d'écriture (SET), la mémoire OxRRAM se trouve dans un état de haute résistance (HRS). Ainsi l'essentiel de la tension appliquée *V_{App}* entre la résistance et la mémoire en série se retrouve aux bornes de l'élément mémoire (i.e. la tension V_{R} aux bornes de la résistance est négligeable devant la tension V_{Ox} aux bornes de la mémoire). Lorsque la tension aux bornes de la mémoire OxRRAM devient suffisante (i.e. supérieure à la tension de seuil VSET) la commutation se produit (basculement du mode HRS vers le mode LRS) et le courant augmente rapidement. La tension aux bornes de la résistance série R augmente pour "encaisser" le surplus de tension. Cette diminution de la tension aux bornes de la cellule mémoire limite donc l'augmentation de courant dans la mémoire.

L'utilisation d'un transistor en série (illustrée en figure 4) est très proche de l'utilisation de la résistance R en série. De la même manière, lors de l'écriture l'augmentation de courant provoque une augmentation de la tension aux bornes du transistor en série. L'avantage d'utiliser un transistor par rapport à une résistance série est de pouvoir contrôler le niveau de limitation à l'aide de la tension de grille. Plus la tension de grille est importante plus le courant de saturation sera important. Le transistor fait ainsi office de moyen de réglage de la limitation de courant dans la mémoire OxRRAM.

Une voie de développement pour les mémoires OxRRAM et CBRAM concerne la rétention de l'information, c'est-à-dire la rétention de l'état « HRS » et de l'état « LRS ». On cherche à améliorer la stabilité des états isolant et conducteur dans le temps.

Il a été démontré que la limitation de courant utilisée pendant l'opération d'écriture SET a une forte influence sur les performances en rétention de l'information.

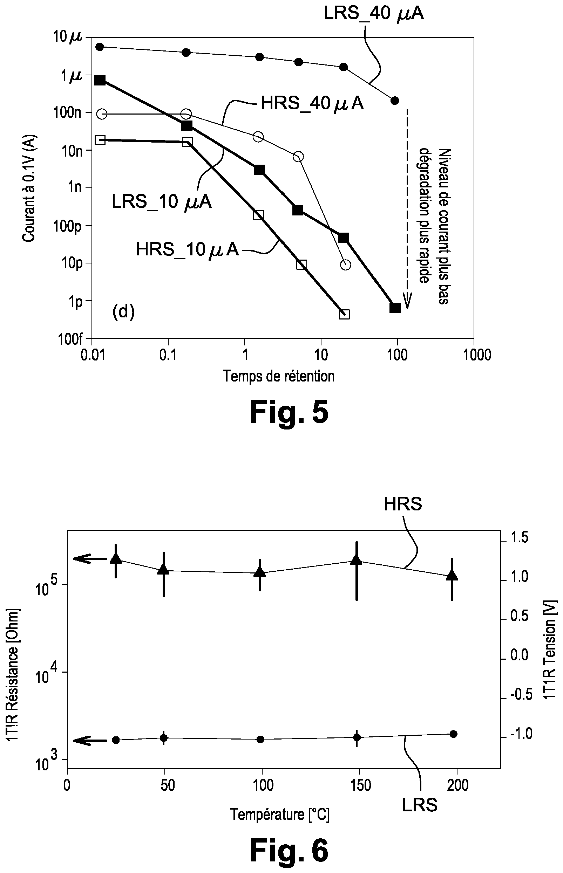

Ainsi, dans l'article "Improvement of data retention in HfO2/Hf 1T1R RRAM cell under low operating current" (Chen Y.Y. et al. - IEEE 2013), il est montré que la limitation de courant pendant l'opération d'écriture SET a une influence importante sur les performances en rétention : la limitation de courant dégrade les performances en rétention. En d'autres termes, une cellule mémoire écrite avec une limitation de courant IC1 a une meilleure stabilité en rétention que lorsqu'elle est écrite avec une limitation de courant IC2 inférieure à IC1. Une diminution de la limitation de courant lors de l'opération d'écriture produit des états LRS avec une résistance plus importante et une stabilité (i.e. une augmentation plus rapide de la résistance et donc une perte de l'information) plus faible. Ce phénomène est illustré en figure 5 qui représente l'évolution du courant à une tension donnée de 0.1V traversant une cellule mémoire une fois écrite dans un état LRS en fonction du temps, cette évolution étant obtenue avec deux limitations de courants différentes: 40µA et 10µA. Cette évolution représente donc l'évolution de la résistance de l'état LRS en fonction du temps. La cellule écrite avec une limitation de 40µA a une meilleure stabilité que celle écrite avec une limitation de 10µA (toutes les autres conditions expérimentales étant égales par ailleurs) et la résistance initiale de SET avec une limitation de 40µA est supérieure à la résistance initiale de SET avec une limitation de 10µA. Les performances en rétention de l'état LRS dépendent donc de la limitation de courant et donc du niveau de la résistance LRS au moment de l'écriture.

Il a par ailleurs été montré (cf. article "Temperature impact (up to 200 ° C) on performance and reliability of HfO2 -based RRAMs" (Cabout T. et al.- IEEE 2013)) que la température de programmation de la mémoire (i.e. la température à laquelle se trouve la mémoire au moment où on réalise l'opération de SET ou de RESET) a très peu d'effet sur les niveaux de résistances des états LRS et HRS de ces mémoires. Les courbes de la figure 6 représentent l'évolution des résistances initiales à l'état LRS (courbe du bas) et HRS (courbe du haut) en fonction de la température de programmation appliquée (respectivement au moment des opérations de SET et de RESET). On observe sur ces courbes que la température n'a quasiment pas d'influence sur les niveaux de résistances. La résistance de l'état LRS est ainsi la même quelle que soit la température d'écriture. On notera qu'il en est de même pour la résistance de l'état HRS.

Le document US-2011-235401 décrit le préambule de la revendication 1.

### RESUME DE L'INVENTION

Dans ce contexte, l'invention vise notamment à proposer un procédé de détermination de paramètres de programmation servant à programmer une mémoire vive résistive de type OxRRAM ou CBRAM offrant une stabilité en rétention améliorée.

A cette fin, un premier aspect de l'invention concerne donc un procédé de détermination de paramètres de programmation servant à programmer une mémoire vive résistive passant d'un état isolant à un état conducteur, ladite mémoire comprenant des première et seconde électrodes séparées par une couche en matériau électriquement isolant, et passant de l'état isolant à l'état conducteur par application d'une tension seuil entre les première et seconde électrodes, le courant circulant dans ladite mémoire après le passage de l'état isolant à l'état conducteur étant limité par des moyens de limitation de courant, ledit procédé comprenant les étapes suivantes :
- détermination des courbes de rétention représentant l'augmentation de la résistance à l'état conducteur en fonction du temps, chaque courbe de rétention étant déterminée pour une température de programmation donnée et une limitation de courant donnée ;
- détermination d'un temps de faute en rétention pour chacune desdites courbes de rétention ;
- détermination des courbes représentant la diminution du temps de faute en rétention en fonction de la température de programmation, chaque courbe étant déterminée pour une limitation de courant donnée ;
- pour au moins une température de programmation donnée, détermination, à partir desdites courbes représentant la diminution du temps de faute en rétention en fonction de la température de programmation, de la valeur de limitation de courant à appliquer à ladite mémoire vive résistive afin d'obtenir un temps de faute en rétention cible.

La présente invention résulte de la constatation surprenante, décrite en détail ultérieurement, que la température de programmation à laquelle est soumise la mémoire vive résistive au moment de son écriture (i.e. opération de SET permettant de faire passer la mémoire de son état hautement résistif HRS à son état bassement résistif LRS) a une influence notable sur les performances en rétention. Ainsi, une écriture à haute température de programmation offrira des performances dégradées en rétention par rapport à une écriture faite à une température de programmation moins élevée. Cette constatation est d'autant plus surprenante que, comme mentionné plus haut, le niveau de résistance de la mémoire au moment de l'écriture ne dépend pas de la température de programmation alors que les performances en rétention dépendent de ce niveau de résistance. Partant du constat que certaines applications (notamment dans l'automobile) nécessitent de maintenir des performances en rétention satisfaisantes quelle que soit la température de programmation, le procédé selon l'invention permet de compenser une éventuelle dégradation des performances en rétention liée à une augmentation de la température de programmation par le choix d'une valeur de limitation de courant adaptée pour assurer cette compensation.

On entend par temps de faute en rétention cible un temps de faute déterminé à partir d'un critère prédéterminé ; à l'état initial (t=0), c'est-à-dire immédiatement après avoir appliqué l'opération d'écriture, la résistance R_{ON} de la mémoire à l'état « LRS » est minimale. Puis, au fil du temps, la résistance à l'état « LRS » augmente. Le critère prédéterminé consiste par exemple à définir un seuil de résistance au-delà duquel on considère que la rétention de l'information n'est plus assurée. Cette résistance seuil est atteinte après une certaine durée de rétention que l'on identifiera comme étant le temps de faute en rétention. A partir de ce seuil, on considère que la mémoire est dans un état d'échec. On pourra par exemple, et de manière non limitative, considérer que l'information dans la cellule mémoire est perdue lorsque sa résistance a augmenté d'un facteur 2 par rapport à sa résistance initiale R_{ON} juste après programmation (t=0).

Outre les caractéristiques qui viennent d'être évoquées dans le paragraphe précédent, le procédé selon un premier aspect de l'invention peut présenter une ou plusieurs caractéristiques complémentaires parmi les suivantes, considérées individuellement ou selon toutes les combinaisons techniquement possibles :
- selon une première variante, le procédé selon l'invention comporte une étape de mesure de la température de programmation avant l'opération d'écriture permettant à la mémoire vive résistive de passer d'un état isolant à un état conducteur, une valeur de limitation de courant étant déterminée pour chaque température de programmation mesurée de façon à obtenir un temps de faute en rétention cible sensiblement constant quelle que soit la valeur de la température mesurée dans une gamme de température donnée ;
- selon une deuxième variante, la température de programmation varie dans une gamme de température donnée, la procédé comportant une étape de détermination d'une valeur de limitation de courant unique correspondant à la borne supérieure de la gamme de température donnée de façon à obtenir un temps de faute en rétention cible à ladite borne supérieure, ladite valeur de limitation unique étant également appliquée à ladite mémoire vive résistive pour des températures inférieures situées dans ladite gamme de température donnée ;

- la détermination des courbes de rétention représentant l'augmentation de la résistance à l'état conducteur en fonction du temps pour une température de programmation donnée et une limitation de courant donnée est réalisée par des mesures expérimentales obtenues sur une ou plusieurs mémoires vives résistives présentant des caractéristiques identiques à la mémoire vive résistive à programmer ;
- selon un mode de réalisation, ladite mémoire vive résistive à programmer est une mémoire de type OxRRAM ;
- selon un autre mode de réalisation, ladite mémoire vive résistive à programmer est une mémoire de type CBRAM ;
- le procédé selon l'invention peut comporter une étape de détermination, pour ledit temps de faute en rétention cible, d'une pluralité de couple de valeurs de température de programmation associée à une limitation de courant ; dans ce cas, le procédé peut également comporter une étape de détermination d'une courbe représentant l'augmentation de la limitation de courant en fonction de la température de programmation.

La présente invention a également pour objet un produit programme d'ordinateur comportant des moyens pour la mise en oeuvre d'un procédé selon l'invention.

L'invention et ses différentes applications seront mieux comprises à la lecture de la description qui suit et à l'examen des figures qui l'accompagnent.

### BREVE DESCRIPTION DES FIGURES

Les figures sont présentées à titre indicatif et nullement limitatif de l'invention.
- La figure 1 illustre schématiquement un dispositif mémoire de type OxRRAM ou CBRAM ;
- La figure 2 illustre la transition abrupte de l'état haute résistance à l'état basse résistance pendant l'opération d'écriture d'un dispositif mémoire de type OxRRAM ou CBRAM ;
- La figure 3 illustre schématiquement la limitation de courant traversant une mémoire OxRRAM par l'utilisation d'une résistance série ;
- La figure 4 illustre schématiquement la limitation de courant traversant une mémoire OxRRAM par l'utilisation d'un transistor série ;
- La figure 5 représente l'évolution du courant dans une mémoire OxRRAM une fois écrite en fonction du temps pour deux limitations de courant différentes ;
- La figure 6 représente l'évolution des résistances initiales à l'état LRS et HRS en fonction de la température de programmation appliquée ;
- La figure 7 représente l'évolution de la résistance d'une mémoire OxRRAM à l'état LRS en fonction du temps pour différentes conditions de programmation ;
- La figure 8 illustre les différentes étapes du procédé de programmation selon l'invention ;
- La figure 9 représente l'évolution de la résistance d'une mémoire OxRRAM à l'état LRS en fonction du temps pour différentes conditions de programmation ainsi que la détermination du temps de faute en rétention ;
- La figure 10 représente l'évolution du temps de faute en rétention en fonction de la température de programmation pour différentes limitations de courant ;
- La figure 11 représente l'évolution de la limitation de courant en fonction de la température de programmation pour un temps de rétention cible donné.

### DESCRIPTION DETAILLEE D'AU MOINS UN MODE DE REALISATION DE L'INVENTION

Sauf précision contraire, un même élément apparaissant sur des figures différentes présente une référence unique.

Le procédé selon l'invention sera décrit plus en détails dans ce qui suit dans le cas d'une mémoire OxRRAM (ou « Oxyde RRAM ») comportant une zone active basée sur un matériau actif à base d'oxyde tel qu'un oxyde binaire d'un métal de transition M (MxOy) entouré de deux électrodes métalliques (cf figure 1). Il s'agit donc d'une structure M-O-M (Métal-Oxyde-Métal) basée sur le changement de résistance de la couche d'oxyde qui passe d'un état hautement résistif HRS à un état bassement résistif LRS lorsqu'on applique une tension d'écriture suffisante VSET aux bornes des électrodes et qui passe d'un état bassement résistif LRS à un état bassement résistif HRS lorsqu'on applique une tension d'écriture suffisante VRESET aux bornes des électrodes. Il existe un nombre important d'oxydes binaires présentant la capacité de changer de résistance de manière réversible. Ces mémoires peuvent être bipolaires (tensions VSET et VRESET de signe opposé) ou unipolaires (VSET et VRESET de même signe) ; elles peuvent également fonctionner dans certains cas dans les deux modes (bipolaire et unipolaire). La mémoire OxRRAM présentée ci-dessous est une mémoire de type TiN/Ti/HfO2/TiN (donc une électrode supérieure formée d'un bicouche TiN/Ti, une région active de mémorisation d'oxyde en HfO2 et une électrode inférieure en TiN) étant entendu que cet exemple est donné à titre purement illustratif et non limitatif, le procédé selon l'invention étant susceptible de s'appliquer à tout type de mémoire OxRRAM (par exemple une structure TiN/Hf/HfO2/TiN ou une structure Ti/HfO2/TiN ou encore une structure Pt/TiO2/Pt). Le procédé selon l'invention s'applique également aux mémoires de type CBRAM présentant un électrolyte solide disposé entre une électrode formant une cathode inerte et une électrode comportant une portion de métal ionisable (versus les mémoires de type OxRRAM dont les électrodes métalliques sont choisies pour être peu facilement ionisables). Un exemple de mémoire CBRAM est par exemple formé par un empilement comportant un électrolyte solide, par exemple à base de chalcogénure dopé (ex. GeS) ou d'oxyde (ex. Al₂O₃) disposé entre une électrode inférieure, par exemple en Pt, formant une cathode inerte, et une électrode supérieure comportant une portion de métal ionisable, par exemple du cuivre, formant une anode.

Comme mentionné plus haut, la présente invention part du constat que, même si la température de programmation n'a pas d'effet sur la résistance de l'état LRS, elle modifie la stabilité de cette état (et donc les performances en rétention d'information). Ainsi, après une écriture à haute température, les performances en rétention sont dégradées. Comme pour certaines applications (par exemple dans le domaine automobile) l'écriture à haute température est indispensable, l'invention vise à proposer un procédé pour maintenir les performances en rétention constantes ou a minima supérieures à un seuil donné, quelle que soit la température de programmation.

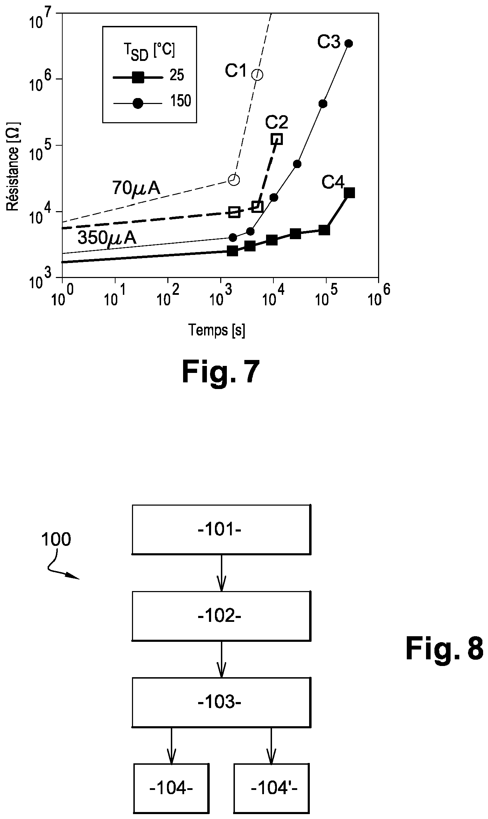

Le phénomène à la base du procédé de programmation selon l'invention est illustré en figure 7 qui montre, pour une mémoire OxRRAM de type TiN/Ti/HfO2/TiN, la rétention de l'état « LRS » représentée par l'évolution de la résistance de la mémoire dans cet état, en fonction du temps.

La figure 7 donne quatre exemples de courbes C1, C2, C3 et C4 de rétention de l'état « LRS » obtenues chacune avec des conditions de programmation initiales différentes (couple de conditions initiales incluant une valeur de limitation de courant et une valeur de température de programmation) :
- La courbe C1 est obtenue avec une limitation de courant de 70µA et une température de programmation de 150°C ;
- la courbe C2 est obtenue avec une limitation de courant de 70µA et une température de programmation de 25°C ;
- la courbe C3 est obtenue avec une limitation de courant de 350µA et une température de programmation de 150°C ;
- la courbe C4 est obtenue avec une limitation de courant de 350µA et une température de programmation de 25°C.

De façon générale, quelle que soit la courbe C1, C2, C3 ou C4, à l'état initial (t=0), c'est-à-dire immédiatement après avoir formé le filament conducteur, la résistance R_{ON} de la mémoire à l'état « LRS » est minimale. Puis, au fil du temps, la résistance à l'état « LRS » augmente.

Sur cette figure 7, on observe donc, en échelle logarithmique, les courbes de rétention pour deux limitations de courants (70µA et 350µA) et pour deux températures de programmation (25°C et 150°C). En d'autres termes, partant d'une même mémoire échantillon, à t=0, on fait passer cette dernière d'un état HRS à un état LRS avec quatre couples de conditions de programmation différents ; les conditions de programmation sont :
- la température de programmation à laquelle la mémoire est écrite ;
- la limitation de courant (compliance) qu'on lui applique.

Pour mémoire, il est nécessaire de limiter par une compliance l'augmentation du courant jusqu'à une certaine valeur afin d'obtenir un état basse résistance tout en gardant un dispositif mémoire intègre (éviter un claquage définitif de l'oxyde). La limitation de courant nécessaire pendant l'opération d'écriture est réalisée par des moyens de limitation de courant dans la mémoire consistant par exemple à utiliser un transistor en série avec la mémoire (cf. figure 4) : la limitation de courant est alors réglable via la commande de la tension de grille du transistor.

Une fois écrite (i.e. une fois le passage à l'état LRS assuré), la mémoire est ensuite placée à une température donnée (dite température de rétention) et on mesure l'évolution de la résistance en fonction du temps. On notera que la température de rétention (ici égale à 250°C) peut être différente de la température de programmation. On utilise souvent une température de rétention plus élevée que la température de fonctionnement de la mémoire prévue par les spécifications industrielles pour pouvoir observer un défaut de rétention de l'information plus rapidement.

Conformément à l'état de la technique précité, on observe sur la figure 7 que les états LRS écrits avec une limitation de courant faible (i.e. 70 µA) sont moins stable (courbes C1 et C2 en tirets) et présentent une résistance initiale plus importante.

En outre, également conformément à l'état de la technique, on observe que la température d'écriture n'a pas d'influence sur la valeur de la résistance initiale (les courbes C1 et C2 obtenues respectivement à 150°C et 25°C pour une même limitation de 70µA ont la même valeur de résistance à l'instant initial ; de même les courbes C3 et C4 obtenues respectivement à 150°C et 25°C pour une même limitation de 350µA ont la même valeur de résistance à l'instant initial).

En revanche, on observe que même si les états initiaux ont la même résistance, la stabilité est dégradée lorsque la cellule est programmée à haute température de programmation (150°C). En d'autres termes, la mémoire selon la courbe C1 perd plus rapidement l'information que la mémoire selon la courbe C2 (avec une même limitation de courant et une valeur de résistance initiale identique) et la mémoire selon la courbe C3 perd plus rapidement l'information que la mémoire selon la courbe C4.

On constate donc que la programmation à haute température fait perdre de la stabilité en rétention alors que l'augmentation du courant de limitation en fait gagner.

Le procédé de programmation selon l'invention tire profit de la constatation ci-dessus pour déterminer une limitation de courant adaptée pour contrôler les performances en rétention.

Les différentes étapes du procédé 100 selon l'invention sont illustrées en figure 8.

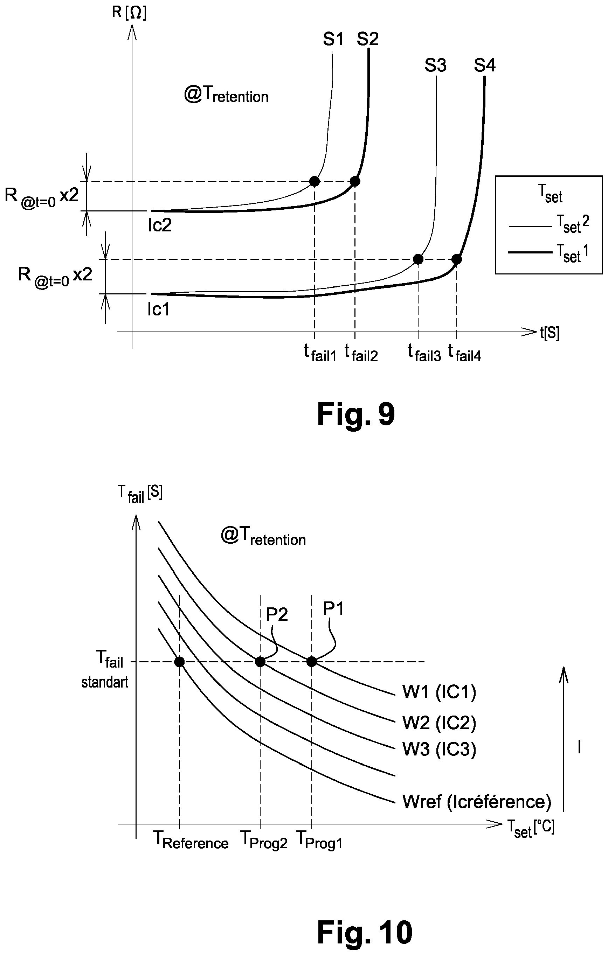

La première étape 101 du procédé selon l'invention va consister à déterminer des courbes de rétention représentant l'augmentation de la résistance à l'état conducteur LRS en fonction du temps, chaque courbe de rétention étant déterminée pour une température de programmation donnée et une limitation de courant donnée ; l'ensemble des courbes est préférentiellement obtenu avec une même température de rétention Trétention plus élevée que la température de fonctionnement de la mémoire prévue par les spécifications industrielles pour pouvoir observer un défaut de rétention de l'information plus rapidement. Les quatre courbes C1 à C4 de la figure 7 sont des exemples de telles courbes. La figure 9 représente également quatre courbes de rétention S1, S2, S3 et S4 visant à illustrer de façon générale le procédé selon l'invention.
- La courbe S1 est obtenue avec une limitation de courant égale à IC2 et une température de programmation de Tset2 (150°C) ;
- la courbe S2 est obtenue avec une limitation de courant égale à IC2 et une température de programmation de Tset1 (25°C) ;
- la courbe S3 est obtenue avec une limitation de courant égale à IC1 et une température de programmation de Tset2 (150°C) ;
- la courbe S4 est obtenue avec une limitation de courant égale à IC1 et une température de programmation de Tset1 (25°C).

Comme mentionné précédemment, on observe que la limitation de courant IC1 strictement supérieure à la limitation de courant IC2 permet de compenser la perte de stabilité en rétention lors de l'utilisation de la température de programmation Tset2 strictement supérieure à la température de programmation Tset1.

Bien entendu, le procédé selon l'invention nécessite l'obtention d'une pluralité de courbes correspondant à de nombreux couples (IC, Tset) différents, les seules courbes S1 à S4 étant données ici à titre purement illustratif.

L'étape 101 est réalisée de manière expérimentale en utilisant une ou plusieurs mémoires OxRRAM de référence ; dans le cas où plusieurs mémoires sont utilisées, il conviendra de choisir des mémoires de référence présentant les mêmes caractéristiques en termes de matériaux et de structure. Le procédé de programmation selon l'invention sera ensuite utilisé pour programmer des mémoires du même type que la ou les mémoires sur lesquelles ont été réalisées les mesures expérimentales.

La seconde étape 102 du procédé selon l'invention va ensuite consister à déterminer un temps de faute en rétention pour chacune des courbes de rétention ; pour ce faire, il convient de choisir un critère d'obtention d'un temps de faute. Ce critère est un critère arbitraire et l'invention n'est absolument pas limitée à un critère particulier. Dans la suite nous utiliserons le critère d'une augmentation de la résistance initiale (résistance de SET à t=0s) d'un facteur 2. Ainsi, on considère que l'information dans la mémoire est perdue lorsque sa résistance a augmenté d'un facteur 2 par rapport à sa résistance initiale juste après sa programmation (à t=0s).

Ainsi, pour chaque courbe S1, S2, S3 et S4, on extrait les temps de faute en rétention (i.e. le temps nécessaire pour que la résistance passe d'une valeur R(t=0) à une valeur R(t=0)x2). Quatre temps de faute tfail1, tfail2, tfail3 et tfail4 correspondent respectivement aux courbes S1, S2, S3 et S4 et donc aux conditions de programmation (IC2, Tset2), (IC2, Tset1), (IC1, Tset2) et (IC1, Tset1).

Selon l'étape 103 du procédé de programmation selon l'invention, on va utiliser les temps de faute en rétention déterminés lors de l'étape précédente 102 pour les placer sur une courbe représentant l'évolution du temps de faute en rétention en fonction de la température de programmation pour différentes limitations de courant. La figure 10 représente ainsi une pluralité de courbes représentant l'évolution du temps de faute en rétention en fonction de la température de programmation pour différentes limitations de courant ; à titre d'exemple, la courbe W1 correspond à l'évolution du temps de faute en rétention en fonction de la température de programmation pour une limitation de courant IC1 ; de même, la courbe W2 correspond à l'évolution du temps de faute en rétention en fonction de la température de programmation pour une limitation de courant IC2, la courbe W3 correspond à l'évolution du temps de faute en rétention en fonction de la température de programmation pour une limitation de courant IC3 et la courbe Wref correspond à l'évolution du temps de faute en rétention en fonction de la température de programmation pour une limitation de courant de référence ICréférence.

Comme mentionné plus haut, on observe de manière générale (i.e. quelle que soit la valeur de limitation de courant) une diminution du temps de faute en rétention lorsque la température de programmation augmente. On observe également que la courbe W1 est au-dessus de la courbe W2 qui est elle-même au-dessus de la courbe W3 qui est elle-même au-dessus de la courbe Wref : cet arrangement s'explique par le fait que le courant IC1 est supérieur au courant IC2 qui est lui-même supérieur au courant IC3 lui-même supérieur au courant ICréference.

Les spécifications d'utilisation des mémoires de type OxRRAM ou CBRAM varient selon les domaines d'application et sont plus ou moins contraignantes. Ainsi, les spécifications peuvent exiger que les mémoires fonctionnent avec un certain temps de rétention sur une gamme de températures données : à titre illustratif, on peut exiger une rétention de 1 à 3 ans sur une gamme de 0°C à 40°C pour des mémoires destinées à la grande consommation ou une rétention plus importante (de l'ordre de 15 ans) dans le domaine de l'automobile avec une gamme très large en température (par exemple de -40°C à 150°C).

Dès lors, selon un premier mode de réalisation, si l'utilisateur veut avoir la même stabilité en rétention pour une ou plusieurs températures d'écriture données (par exemple T_{Prog1} et T_{Prog2}), le procédé de programmation selon l'invention va comporter une étape 104 consistant à tracer une droite horizontale sur les courbes de la figure 10 correspondant au temps de faute en rétention cible (t_{fail_standard}) qu'il souhaite obtenir (par exemple pour une température de programmation T_{réference} et la limitation de courant IC_{référence}) et à tracer une droite verticale correspondant à chaque température d'écriture considérée (ici T_{Prog1} et T_{Prog2}).

L'intersection de ces deux droites donne le point de fonctionnement voulu pour obtenir les mêmes performances en rétention (i.e. avoir le même temps de faute en rétention quelle que soit la température de programmation de la gamme de températures prévue par les spécifications). Il suffit alors à l'utilisateur d'utiliser la limitation de courant correspondant à la courbe passant sur ce point. Ici pour les deux températures de programmation T_{Prog1} et T_{prog2} on obtient respectivement les deux courants de programmation Ic1 et Ic2 correspondant aux deux points de fonctionnement P1 et P2.

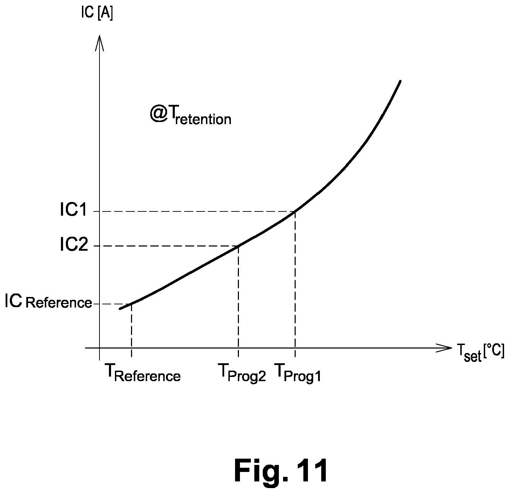

L'ensemble de ces points de fonctionnement peut ensuite être utilisé pour représenter l'évolution de la limitation de courant en fonction de la température de programmation pour un même temps de rétention cible donné. Cette courbe est illustrée en figure 11.

La mise en oeuvre de ce premier mode de réalisation suppose donc de mesurer la température de la mémoire à programmer ; en fonction de la température mesurée et connaissant le temps de rétention cible, on en déduit le courant de limitation à appliquer à la mémoire ; cette limitation de courant est par exemple réglée via la grille d'un transistor en série avec ladite mémoire. Selon ce mode de réalisation, le dispositif intégrant la ou les mémoires à programmer est équipé de moyens de mesure de température permettant de fournir une mesure de la température au moment de la programmation de la ou des mémoires et donc de déterminer le point de fonctionnement (i.e. la limitation de courant associée à la température de programmation) pour obtenir le temps de rétention cible recherché.

Selon une alternative au premier mode de réalisation, l'utilisateur peut décider d'avoir une stabilité satisfaisante en rétention (et non nécessairement identique) pour une ou plusieurs températures d'écriture données ; pour ce faire, le procédé de programmation selon l'invention va comporter une étape 104' consistant à choisir la température maximale de la gamme de températures visée par les spécifications puis à déterminer, à partir des courbes de la figure 10, la limitation de courant à appliquer, pour obtenir un temps de rétention voulu ; cette limitation de courant ainsi déterminée sera appliquée à la mémoire sur toute la gamme de température ; en d'autres termes, on va « sur-dimensionner » la limitation de courant de manière à avoir un temps de rétention voulue dans la condition de température de programmation maximale ; à titre illustratif, dans la gamme [T_{référence} - T_{prog2}], pour obtenir un temps de faute en rétention cible (t_{fail_standard}), on se place à la température T_{Prog2}; on en déduit la limitation de courant Ic2 à appliquer. Cette limitation de courant Ic2 sera appliquée à la mémoire quelle que soit la température dans la gamme [T_{référence} - T_{prog2}].

## Revendications

1. Procédé de détermination de paramètres de programmation servant à programmer une mémoire vive résistive passant d'un état isolant à un état conducteur, ladite mémoire comprenant des première et seconde électrodes séparées par une couche en matériau électriquement isolant, et passant de l'état isolant à l'état conducteur par application d'une tension seuil entre les première et seconde électrodes, le courant circulant dans ladite mémoire après le passage de l'état isolant à l'état conducteur étant limité par des moyens de limitation de courant, ledit procédé étant **caractérisé en ce qu'**il comprend les étapes suivantes :
- détermination des courbes de rétention représentant l'augmentation de la résistance à l'état conducteur en fonction du temps, chaque courbe de rétention étant déterminée pour une température de programmation donnée et une limitation de courant donnée ;
- détermination d'un temps de faute en rétention pour chacune desdites courbes de rétention ;
- détermination des courbes représentant la diminution du temps de faute en rétention en fonction de la température de programmation, chaque courbe étant déterminée pour une limitation de courant donnée ;
- pour au moins une température de programmation donnée, détermination, à partir desdites courbes représentant la diminution du temps de faute en rétention en fonction de la température de programmation, d'une valeur de limitation de courant à appliquer à ladite mémoire vive résistive afin d'obtenir un temps de faute en rétention cible.

2. Procédé selon la revendication 1 **caractérisé en ce qu'**il comporte une étape de mesure de la température de programmation avant l'opération d'écriture permettant à la mémoire vive résistive de passer d'un état isolant à un état conducteur, une valeur de limitation de courant étant déterminée pour chaque température de programmation mesurée de façon à obtenir un temps de faute en rétention cible sensiblement constant quelle que soit la valeur de la température mesurée dans une gamme de température donnée.

3. Procédé selon la revendication 1 **caractérisé en ce que** la température de programmation varie dans une gamme de température donnée, la procédé comportant une étape de détermination d'une valeur de limitation de courant unique correspondant à la borne supérieure de la gamme de température donnée de façon à obtenir un temps de faute en rétention cible à ladite borne supérieure, ladite valeur de limitation unique étant également appliquée à ladite mémoire vive résistive pour des températures inférieures situées dans ladite gamme de température donnée.

4. Procédé selon l'une des revendications précédentes **caractérisé en ce que** la détermination des courbes de rétention représentant l'augmentation de la résistance à l'état conducteur en fonction du temps pour une température de programmation donnée et une limitation de courant donnée est réalisée par des mesures expérimentales obtenues sur une ou plusieurs mémoires vives résistives présentant des caractéristiques identiques à la mémoire vive résistive à programmer.

5. Procédé selon l'une des revendications précédentes **caractérisé en ce qu'**il comporte une étape de détermination, pour ledit temps de faute en rétention cible, d'une pluralité de couple de valeurs de température de programmation associée à une limitation de courant.

6. Procédé selon la revendication précédente **caractérisé en ce qu'**il comporte une étape de détermination d'une courbe représentant l'augmentation de la limitation de courant en fonction de la température de programmation.

7. Procédé selon l'une des revendications précédentes dans lequel la mémoire vive résistive est une mémoire de type OxRRAM.

8. Procédé selon l'une des revendications 1 à 6 dans lequel la mémoire vive résistive est une mémoire de type CBRAM.

9. Produit programme d'ordinateur comportant un code de programme qui lorsqu'il est exécuté sur un ordinateur exécute les étapes du procédé selon l'une quelconque des revendications 1 à 8.

## Patentansprüche

1. Bestimmungsverfahren von Programmierparametern, die zum Programmieren eines ohmschen Arbeitsspeichers dienen, der von einem isolierenden Zustand in einen leitenden Zustand übergeht, wobei der genannte Speicher erste und zweite Elektroden umfasst, die durch eine Schicht aus elektrisch isolierendem Material getrennt sind und von dem isolierenden Zustand in den leitenden Zustand durch die Anwendung einer Schwellenspannung zwischen der ersten und der zweiten Elektrode übergehen, wobei der Strom, der in dem genannten Speicher nach dem Übergang vom isolierenden Zustand in den leitenden Zustand fließt, durch Strombegrenzungsmittel begrenzt wird, wobei das genannte Verfahren **dadurch gekennzeichnet ist, dass** es die folgenden Schritte umfasst:
- Bestimmung der Retentionskurven, die die Erhöhung des Widerstandes im leitenden Zustand in Abhängigkeit von der Zeit darstellen, wobei jede Retentionskurve für eine bestimmte Programmiertemperatur und eine bestimmte Strombegrenzung bestimmt ist;
- Bestimmung einer Fehlerzeit bei der Retention für jede der genannten Retentionskurven;
- Bestimmung der Kurven, die die Abnahme der Fehlerzeit bei der Retention in Abhängigkeit von der Programmiertemperatur darstellen, wobei jede Kurve für eine bestimmte Strombegrenzung bestimmt ist;
- für wenigstens eine bestimmte Programmiertemperatur die Bestimmung eines Strombegrenzungswertes, der auf den ohmschen Arbeitsspeicher anzuwenden ist, ausgehend von den genannten Kurven, die die Abnahme der Fehlerzeit bei der Retention in Abhängigkeit von der Programmiertemperatur darstellen, um eine Zielfehlerzeit in der Retention zu erhalten.

2. Verfahren gemäß Anspruch 1, **dadurch gekennzeichnet, dass** es einen Messschritt der Programmiertemperatur vor der Schreiboperation umfasst, die dem ohmschen Arbeitsspeicher den Übergang von einem isolierenden Zustand in einen leitenden Zustand erlaubt, wobei ein Strombegrenzungswert für jede gemessene Programmiertemperatur derart bestimmt wird, dass eine deutlich konstante Fehlerzeit unabhängig von dem Wert der Temperatur erhalten wird, die in einem bestimmten Temperaturspektrum gemessen wird.

3. Verfahren gemäß Anspruch 1, **dadurch gekennzeichnet, dass** die Programmiertemperatur in einem bestimmten Temperaturspektrum variiert, wobei das Verfahren einen Bestimmungsschritt eines einmaligen Strombegrenzungswertes umfasst, der der oberen Grenzmarkierung des bestimmten Temperaturspektrums derart entspricht, dass eine Fehlerzeit bei der Zielretention an der oberen Grenzmarkierung erhalten wird, wobei der genannten einmalige Grenzwert ebenfalls auf den genannte ohmschen Arbeitsspeicher für untere Temperaturen angewendet wird, die sich in dem genannten Temperaturspektrum befinden.

4. Verfahren gemäß irgendeinem der voranstehenden Ansprüche, **dadurch gekennzeichnet, dass** die Bestimmung der Retentionskurven, die die Erhöhung des Widerstandes im leitenden Zustand in Abhängigkeit von der Zeit für eine bestimmte Programmierzeit und eine bestimmte Strombegrenzung darstellen, durch experimentelle Messungen realisiert wird, die auf einem oder mehreren ohmschen Arbeitsspeicher erhalten werden, die mit dem zu programmierenden ohmschen Arbeitsspeicher identische Merkmale aufweisen.

5. Verfahren gemäß einem der voranstehenden Ansprüche, **dadurch gekennzeichnet, dass** es einen Bestimmungsschritt für die genannte Fehlerzeit bei der Zielretention einer Vielzahl von Wertepaaren der Programmiertemperatur umfasst, die einer Strombegrenzung zugeordnet ist.

6. Verfahren gemäß dem voranstehenden Anspruch, **dadurch gekennzeichnet, dass** es einen Bestimmungsschritt einer Kurve umfasst, die die Erhöhung der Strombegrenzung in Abhängigkeit von der Programmiertemperatur darstellt.

7. Verfahren gemäß einem der voranstehenden Ansprüche, bei dem der ohmsche Widerstand ein Speicher vom Typ OxRRAM ist.

8. Verfahren gemäß irgendeinem der Ansprüche 1 bis 6, bei dem der ohmsche Arbeitsspeicher ein Speicher vom Typ CBRAM ist.

9. Computerprogrammprodukt, das einen Programmcode umfasst, der, wenn er auf einem Computer ausgeführt wird, die Schritte des Verfahrens gemäß irgendeinem der Ansprüche 1 bis 8 ausführt.

## Claims

1. Method for determining programming parameters for programming a resistive memory switching from an insulating state to a conducting state, said memory including first and second electrodes separated by a layer made of electrically insulating material, and switching from the insulating state to the conducting state by application of a threshold voltage between the first and second electrodes, the current flowing in said memory after switching from the insulating state to the conducting state being limited by current limitation means, said method being **characterised in that** it includes the following steps:
- determining retention curves representing the increase in the resistance in the conducting state as a function of time, each retention curve being determined for a given programming temperature and a given current limitation;
- determining a retention failure time for each of said retention curves;
- determining curves representing the decrease in the retention failure time as a function of the programming temperature, each curve being determined for a given current limitation;
- for at least one given programming temperature, determining, from said curves representing the decrease in the retention failure time as a function of the programming temperature, a current limitation value to be applied to said resistive memory in order to obtain a target retention failure time.

2. Method according to claim 1 **characterised in that** it comprises a step of measuring the programming temperature before the writing operation enabling the resistive memory to switch from an insulating state to a conducting state, a current limitation value being determined for each programming temperature measured so as to obtain a substantially constant target retention failure time whatever the temperature value measured in the given temperature range.

3. Method according to claim 1 **characterised in that** the programming temperature varies in a given temperature range, the method comprising a step of determining a unique current limitation value corresponding to the upper limit of the given temperature range so as to obtain a target retention failure time at said upper limit, said unique limitation value also being applied to said resistive memory for lower temperatures situated in the given temperature range.

4. Method according to one of the preceding claims **characterised in that** the determination of the retention curves representing the increase in the resistance in the conducting state as a function of time for a given programming temperature and a given current limitation is carried out by experimental measurements obtained on one or more resistive memories having identical characteristics to the resistive memory to programme.

5. Method according to one of the preceding claims **characterised in that** it comprises a step of determining, for said target retention failure time, a plurality of pairs of programming temperature values associated with a current limitation.

6. Method according to the preceding claim **characterised in that** it comprises a step of determining a curve representing the increase in the current limitation as a function of the programming temperature.

7. Method according to one of the preceding claims in which the resistive memory is an OxRRAM type memory.

8. Method according to one of claims 1 to 6 in which the resistive memory is a CBRAM type memory.

9. Computer programme product comprising a programme code which, when it is run on a computer, executes the steps of the method according to any of claims 1 to 8.
